Europäisches Patentamt

European Patent Office

Office européen des brevets

(19)

(11) Numéro de publication : **0 014 628**
**B1**

(12) FASCICULE DE BREVET EUROPÉEN

(45) Date de publication du fascicule du brevet :
28.12.83

(51) Int. Cl.³ : **H 03 H 19/00**

(21) Numéro de dépôt : **80400125.3**

(22) Date de dépôt : **25.01.80**

(54) **Filtre suiveur à commutation.**

(30) Priorité : 02.02.79 FR 7902752

(43) Date de publication de la demande :
**20.08.80 Bulletin 80/17**

(45) Mention de la délivrance du brevet :
**28.12.83 Bulletin 83/52**

(84) Etats contractants désignés :
**DE GB IT NL**

(56) Documents cités :
**FR-A- 2 044 367**
**ELECTRONICS LETTERS, vol. 4, no. 18, 18 september 1968, Londres GB R. MACARIO: "High-Q factor shunt-switched N-path filters", pages 382-383**
**JOURNAL OF PHYSICS E; SCIENTIFIC INSTRU-MENTS, vol. 8, no. 11, novembre 1975, Londres GB Y. KOMACHI: "Lock-in amplifier using a sampled-data synchronous filter", pages 967-971**

(73) Titulaire : **COMMISSARIAT A L'ENERGIE ATOMIQUE Etablissement de Caractère Scientifique Technique et Industriel**
**B.P. 510**
**F-75752 Paris Cedex 15 (FR)**

(72) Inventeur : **Gignoux, Michel**
**15bis, Avenue A. Croizat**
**F-38600 Fontaine (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Filtre suiveur à commutation

La présente invention concerne un filtre suiveur à commutation à $n$ chemins commutés, du type passe-bande, à bande étroite, dans lequel le signal de synchronisation des commutations est prélevé en aval du filtre.

Cette invention s'applique au filtrage d'un signal présentant une composante utile de fréquence variable, associée à un bruit de fond important.

Un filtre suiveur à commutation de type passe-bande, à bande étroite, doit présenter une bande passante très étroite, centrée sur la fréquence de la composante utile du signal d'entrée ; ce filtre doit en outre pouvoir capturer, puis suivre la fréquence fondamentale du signal d'entrée, c'est-à-dire que la fréquence centrale de sa bande passante doit coïncider automatiquement et à chaque instant avec la fréquence fondamentale de la composante utile du signal.

On connaît des filtres à commutation, à commande numérique qui présentent un certain nombre $n$ de chemins (par exemple de circuits à résistance-capacité), connectés séquentiellement entre l'entrée et la sortie du filtre ; ce type de filtres est particulièrement sélectif et la fréquence centrale de leur bande passante dépend du nombre de cycles de commutation effectué par seconde, indépendamment des valeurs des composants, tels que résistances et capacités, qui n'interviennent que pour caractériser la sélectivité du filtre. Ce type de filtre peut difficilement agir lorsque la fréquence du signal d'entrée varie dans une assez large bande de fréquence. Généralement, lorsqu'il s'agit de capturer puis de suivre un signal dont la fréquence évolue dans une très large bande, on utilise différents moyens qui permettent de commander le filtre de manière que sa fréquence centrale coïncide avec la fréquence utile ou fondamentale du signal d'entrée. Ces différents moyens ne donnent de bons résultats que si le signal périodique d'entrée à suivre ou à capturer n'évolue que dans une faible bande de fréquences, et si ce signal n'est pas affecté d'un bruit trop important.

Ces moyens de commande sont constitués de manière à piloter le filtre à commutation, présentant $n$ chemins, par une fréquence extérieure de référence $F_R$ qui doit être synchronisée, soit sur le fondamental du signal d'entrée, soit sur le signal de sortie du filtre.

Lorsque la fréquence $F_R$ est synchronisée sur le fondamental du signal d'entrée, on parle de filtre suiveur à commutation, « à synchronisation amont ». Dans ce cas, il est nécessaire, pour commander la commutation des $n$ chemins du filtre, de prélever le signal d'entrée, de le conditionner, de le filtrer dans un filtre passe-bande grossier, puis de le multiplier par le nombre $n$ de commutations à effectuer. Ce type de commande des commutations ne donne de bons résultats que si le signal d'entrée est peu bruité et que si la bande de fréquences dans laquelle il évolue est étroite. Ces conditions sont en effet nécessaires pour que le signal de commande des commutations, qui résulte de la multiplication de la fréquence du signal d'entrée par le nombre $n$ soit lui-même peu bruité. En effet, tous les phénomènes indésirables et en particulier le bruit qui se superpose au signal périodique d'entrée se retrouvent sur la voie de multiplication et sont multipliés. Il en résulte qu'avant de multiplier le signal d'entrée pour commander les commutations, il est nécessaire de placer devant le multiplieur de fréquence du signal d'entrée un filtre passe-bande à bande assez étroite. Malheureusement, ce filtre limite de même la plage de poursuite du filtre suiveur à commutations. Il en résulte que si l'on désire obtenir une plage de poursuite étendue, il est nécessaire de placer devant le multiplieur un filtre à bande large qui n'élimine pas suffisamment le bruit superposé au signal périodique d'entrée ; ceci entraîne, en sortie du filtre à commutation, une agitation en phase importante. Un compromis est donc difficile à trouver entre la plage de poursuite et le bruit, puisque si l'on place devant le multiplieur un filtre à bande trop étroite, la plage de poursuite du filtre suiveur est elle-même très étroite.

Il résulte de ces observations qu'un filtre suiveur à commutation « à synchronisation amont » n'est utilisé, dans la plupart des cas, que pour filtrer des signaux périodiques dont la fréquence s'écarte peu d'une valeur prédéterminée ; c'est le cas par exemple de signaux périodiques du secteur à 50 ou 60 hertz.

Un autre moyen pour commander les commutations des $n$ chemins du filtre suiveur consiste à synchroniser les commutations en prélevant le signal synchrone du signal d'entrée sur la sortie du filtre suiveur. On dira dans ce cas que le filtre suiveur à commutation est à « synchronisation aval ». Dans ce cas, le signal de synchronisation qui est prélevé en aval du filtre suiveur à commutation est déjà filtré énergiquement et il est à nouveau filtré par un filtre passe-bas, avant d'attaquer le multiplieur destiné à commander les commutations du filtre suiveur. Les seules limitations qui apparaissent dans ce type de commande des commutations des $n$ chemins du filtre suiveur concernent la plage de fonctionnement du multiplieur et celle du filtre passe-bas qui le précède. Ce filtre passe-bas est nécessaire pour lisser le signal filtré en provenance du filtre suiveur. En effet, ce signal filtré se présente sous la forme de marches d'escalier qui peuvent produire des ambiguïtés, notamment au passage à zéro du signal filtré.

Dans ce type de filtre suiveur à commutation par « synchronisation aval », le filtre n'est pas excité au départ et il est nécessaire de prévoir un circuit de démarrage permettant la capture du signal d'entrée ; ce circuit de démarrage est constitué de manière à ajuster la fréquence centrale du filtre à commutation sur la fréquence fondamentale du signal d'entrée. En effet, la fonction de transfert d'un filtre à n chemins ou n circuits est constituée par la fonction de transfert élémentaire du circuit placé dans l'un des chemins, périodisée dans le domaine des fréquences. Ainsi, cette fonction de transfert élémentaire est étroite, et c'est en particulier ce que l'on recherche dans le filtrage sélectif ; la fonction de transfert résultante se présente comme une suite de raies d'autant plus étroites que n est grand. L'allure de cette série de raies conduit à qualifier ce filtre à commutation de « filtre en peigne ».

On peut également citer comme filtre élémentaire, outre les filtres passifs d'ordre supérieur à 1, des filtres actifs du premier ordre ou d'ordre supérieur (de la classe des filtres analogiques à référence interne), des filtres numériques (à référence externe mais à sortie numérique ; les signaux de sortie d'un tel filtre à n chemins sont dans ce cas constitués par une suite de mots numériques). Enfin, on peut citer les filtres analogiques à référence externe ou encore les filtres à commutation de capacité proprement dits.

Dans le cas d'un filtre suiveur à commutation à n chemins, à synchronisation aval, il est possible de disposer dans la série des capacités des chemins, un certain nombre N d'entre elles, de valeurs plus faibles. Au départ, le filtre se comporte comme un filtre à M positions seulement avec une constante de temps plus faible ; cette constante de temps est en effet, dans ce cas, égale à MRC au lieu de nRC, si R et C désignent les valeurs des résistances et des capacités de chacun des chemins. Il en résulte que le filtre présente au départ une bande passante plus large et peut englober alors la fréquence recherchée. Une fois la capture effectuée, le filtre se comporte comme un filtre de largeur comprise entre 2/MRC et 2/nRC.

Comme on le verra plus loin en détail, le signal de synchronisation des commutations peut être obtenu à partir de la sortie du filtre si sa fonction de transfert est telle qu'une partie suffisante du signal d'entrée passe vers la sortie du filtre ; ce signal de synchronisation peut également être tel qu'il modifie la fonction de transfert du filtre de manière à laisser passer en sortie de celui-ci une part contrôlable du signal d'entrée.

Dans le cas d'un filtre à commutation très sélectif, le signal présent à l'entrée n'a aucune chance de se retrouver en sortie, si le filtre n'est pas associé à un circuit de démarrage permettant la capture du signal d'entrée.

Différents dispositifs de démarrage ou de capture du signal sont connus ; ils agissent soit sur le signal pilote en le branchant provisoirement sur une référence locale dont on fait varier progressivement la fréquence, soit sur la largeur du filtre. Lorsque la capture a eu lieu, le circuit de démarrage ou de capture est débranché. Le filtre suit alors seul le signal d'entrée, à condition que la variation instantanée de celui-ci ne dépasse pas la largeur de la bande passante de ce filtre.

Les filtres connus, qui viennent d'être décrits ainsi que les circuits de capture ou de démarrage qui leur sont associés présentent tous une discontinuité de fonctionnement. En effet, il faut successivement rechercher le signal d'entrée puis le suivre ; ceci exige de passer d'un mode de fonctionnement à l'autre. Il en résulte une complication des circuits ou dispositifs annexes de commande du filtre à commutation, ce qui peut entraîner un fonctionnement intempestif ou inopiné du système de capture dans certaines circonstances ; il est donc souvent nécessaire de prévoir des procédures supplémentaires qui évitent ces inconvénients.

La présente invention a pour but de remédier aux inconvénients exposés ci-dessus, et notamment de réaliser un filtre suiveur à commutation dans lequel la poursuite et la capture du signal d'entrée sont réalisées grâce à des moyens simples faisant intervenir des moyens qui permettent de prélever un signal préfiltré de synchronisation des commutations, de sorte que dans ce signal préfiltré subsiste une partie du signal d'entrée du filtre ; ces moyens n'introduisent aucune limitation de la plage de fréquence dans laquelle peut évoluer le signal d'entrée, ils sont peu sensibles au bruit de fond accompagnant le fondamental de ce signal d'entrée et permettent de conserver aux filtres suiveurs à commutation leur caractère très sélectif. Le filtre suiveur de l'invention peut présenter des chemins identiques ou non.

Les moyens qui assurent la capture et la poursuite du signal d'entrée modifient la fonction de transfert du filtre, de manière qu'avant la capture du signal d'entrée à fréquence variable, une partie de l'amplitude de ce signal d'entrée subsiste en sortie du filtre ; ces moyens agissent sur les chemins de manière que le filtre assure la capture et la poursuite du signal d'entrée, quand la fréquence de ce signal varie.

L'invention a pour objet un filtre suiveur à commutation à n chemins, de type passe-bande, à bande étroite, comportant dans chaque chemin un élément réactif situé dans une branche transversale du chemin respectif, reliée d'une part à un potentiel de référence et d'autre part, à un point du chemin disposé entre l'entrée et la sortie du filtre, chaque chemin étant commuté par l'intermédiaire d'au moins un commutateur commandé par des moyens de commande d'ouverture et de fermeture prélevant à la sortie du filtre un signal de synchronisation des commutations des n chemins, caractérisé en ce que ladite branche transversale comporte entre le potentiel de référence et le point situé sur le chemin entre l'entrée et la sortie du filtre une impédance de modification branchée en série avec l'élément réactif lorsque le commutateur associé au chemin est fermé modifiant ainsi, en raison de son dimensionnement, la fonction de transfert du filtre, de telle façon qu'avant la capture du signal d'entrée à fréquence variable, une partie de l'amplitude de ce signal d'entrée subsiste en sortie du filtre.

Selon une caractéristique particulière, chaque branche transversale contient une impédance de modification distincte.

Selon une autre caractéristique particulière, les branches transversales sont reliées à un point commun et l'impédance de modification, commune à tous les chemins, est branchée entre ce point et le potentiel de référence.

Selon une autre caractéristique, ladite impédance de modification comprend une résistance connectée en parallèle avec un condensateur.

Selon une autre caractéristique, ladite impédance comprend une résistance réglable, connectée en parallèle avec un condensateur.

Selon une autre caractéristique, le filtre comprend des moyens pour supprimer ladite impédance en cours de fonctionnement du filtre.

Selon une autre caractéristique, les moyens de commande (M) d'ouverture et de fermeture comprennent un amplificateur à commande automatique de gain connecté en sortie du filtre, de manière à amplifier le signal de synchronisation prélevé pour cette sortie.

Selon une autre caractéristique, chaque chemin comprend un autre commutateur commandé par les moyens de commutation, l'un des commutateurs mettant ce chemin en commutation avec l'entrée, l'autre le mettant en communication avec la sortie, le filtre comportant en outre, connectés en parallèle sur les commutateurs de sortie, un jeu de commutateurs, et des moyens pour déphaser les signaux de commande des commutateurs de ce jeu, par rapport aus signaux de commande des commutateurs d'entrée et de sortie.

Selon une autre caractéristique, chaque chemin comprend un autre commutateur commandé par les moyens de commutation, l'un des commutateurs mettant ce chemin en communication avec l'entrée, l'autre le mettant en communication avec la sortie, le filtre comportant en outre, connectés en parallèle sur les commutateurs de sortie, un jeu de commutateurs, et des moyens pour commander les commutateurs de ce jeu, à fréquence fixe.

Selon une autre caractéristique, chaque chemin comprend un autre commutateur commandé par les moyens de commutation, l'un des commutateurs mettant ce chemin en commutation avec l'entrée, l'autre le mettant en communication avec la sortie, le filtre comprenant en outre, connectés en parallèle avec les commutateurs de sortie, un jeu de commutateurs, et des moyens pour commander les commutateurs de ce jeu à une fréquence proportionnelle à la fréquence du signal d'entrée.

D'autres caractéristiques particulières et avantages de l'invention ressortiront mieux de la description qui va suivre, donnée à titre purement illustratif, en référence aux dessins annexés dans lesquels :

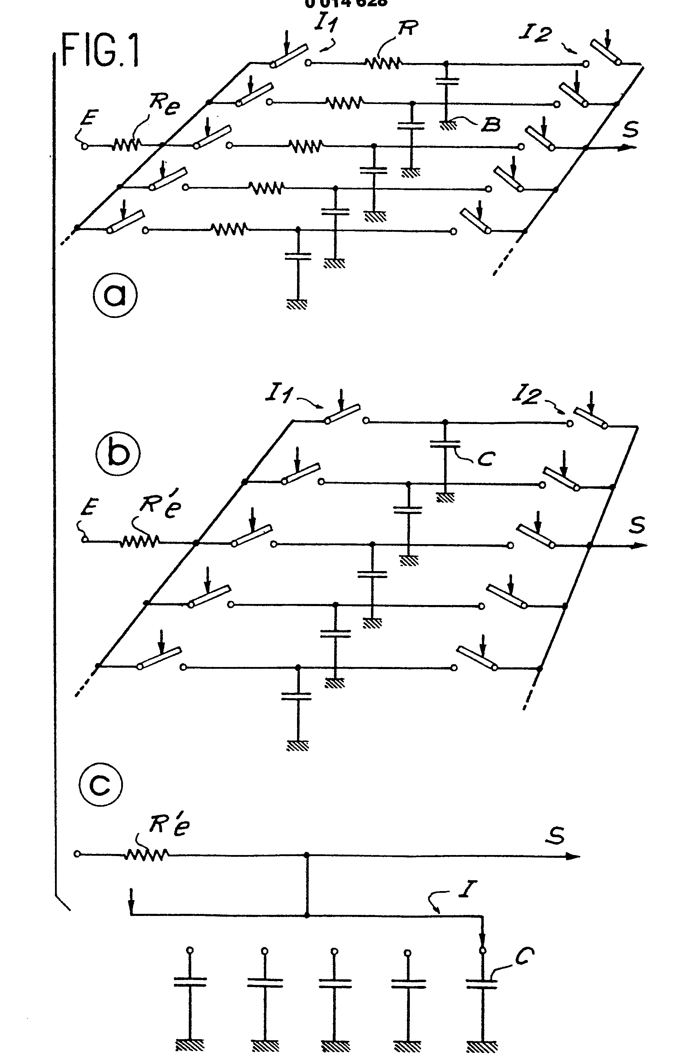

la figure 1 représente :

— en (a), un filtre à commutation à $n$ chemins, de type « série », connu dans l'état de la technique,

— en (b), un schéma équivalent du filtre à commutation de type « série » précédent,

— en (c), un filtre à commutation à $n$ chemins, de type « shunt », connu dans l'état de la technique et dont le schéma est tiré du schéma équivalent du filtre à structure « série », de la figure 1b ;

la figure 2 est un diagramme illustrant la fonction de transfert $F_T$ de l'un des filtres précédents, en fonction de la fréquence $f$ du signal à l'entrée de ce filtre ;

la figure 3 représente schématiquement un filtre suiveur à commutation à $n$ chemins, de type « série », conforme à l'invention, incluant une impédance permettant de modifier la fonction de transfert du filtre ; cette impédance est reliée en série avec l'ensemble des éléments réactifs des $n$ chemins ;

la figure 4 représente schématiquement un filtre suiveur à commutation à $n$ chemins, de type « shunt », conforme à l'invention, incluant une impédance permettant de modifier la fonction de transfert du filtre ; cette impédance est reliée en série avec l'ensemble des éléments réactifs des $n$ chemins ;

la figure 5 représente schématiquement un filtre suiveur à commutation à $n$ chemins, de type « série », incluant une boucle de commande de synchronisation des commutations des chemins ; dans le filtre représenté sur ce schéma, une impédance modifiant la fonction de transfert du filtre est reliée en série avec l'élément réactif de chaque chemin ;

la figure 6 représente schématiquement un filtre suiveur à commutation à $n$ chemins, de type « shunt », incluant des moyens pour prélever en aval du filtre un signal de synchronisation des commutations des chemins ; dans le filtre représenté sur ce schéma, une impédance modifiant la fonction de transfert du filtre est reliée en série avec l'élément réactif de chaque chemin ;

la figure 7 représente un mode de réalisation des moyens permettant de prélever en aval du filtre un signal de synchronisation des commutations des chemins ; dans ce mode de réalisation, ces moyens incluent notamment un amplificateur à commande automatique de gain ;

la figure 8 représente un mode de réalisation particulier des moyens permettant de prélever, en aval du filtre, un signal de synchronisation des commutations des chemins ; dans ce mode de réalisation, ces moyens incluent notamment une boucle à verrouillage de phase ;

la figure 9 représente schématiquement un filtre suiveur à commutation, conforme à l'invention, permettant de déphaser le signal filtré par rapport à la composante utile du signal d'entrée ;

la figure 10 est un diagramme illustrant la fonction de transfert $F_T$ d'un filtre suiveur à commutation conforme à l'invention, tel que représenté sur l'une des figures 3 à 9 et qui présente une impédance permettant de modifier la fonction de transfert du filtre, de manière à laisser passer en sortie du filtre une partie du signal d'entrée ;

la figure 11 représente un autre mode de réalisation des moyens qui permettent de prélever un signal de synchronisation des commutations.

En référence à la figure 1, on a représenté en a) un filtre à commutation à $n$ chemins, de type « série », connu dans l'état de la technique. Ce filtre comprend une résistance d'entrée $R_2$ reliée en série avec $n$ cellules de filtrage présentes respectivement sur $n$ chemins commutables par l'intermédiaire de commutateurs commandables tels que $l_1$, $l_2$. Chaque cellule de filtrage, dans l'exemple de réalisation représenté, est constituée par une résistance R associée à un condensateur C dont l'une des bornes est portée à un potentiel de référence B. Le signal d'entrée à filtrer est appliqué à l'entrée E du filtre, tandis que le signal filtré de sortie est obtenu en S. Ce type de filtre à commutation, connu dans l'état de la technique, peut être qualifié de filtre à commutation à $n$ chemins échantillonnés de manière répétitive ; il est très sélectif et il fonctionne en prélevant une partie du signal d'entrée successivement sur les $n$ chemins disposés en travers du passage de ce signal. Généralement, les cellules de filtrage des différents chemins sont identiques et les instants où l'on prélève le signal dans chaque chemin sont régulièrement répartis dans le temps et ne se recoupent pas lorsque l'on passe d'un chemin au suivant, d'une manière cyclique. On n'a pas représenté sur cette figure les moyens connus qui permettent de commander les commutateurs $l_1$, $l_2$, de manière cyclique ; ces moyens peuvent être constitués de circuits logiques, tandis que les commutateurs $l_1$, $l_2$ commandables, peuvent être constitués par des transistors à effet de champ. Comme les $n$ chemins sont commutés cycliquement et se succèdent en travers du passage du signal, la réponse du filtre n'est pas indépendante du temps. Si la constante de temps de chaque cellule de filtrage de chaque chemin est grande vis-à-vis du temps de commutation, la fonction de transfert résultante est symétrique par rapport à la fréquence de commutation. Si le signal sinusoïdal appliqué à l'entrée du filtre présente une composante fondamentale de fréquence $f_0$, à chaque période, chaque capacité C est sollicitée par la valeur du signal qui lui revient au cours du cycle. Cette valeur ne change pas si la commutation est synchrone de la composante fondamentale du signal d'entrée. Chaque capacité se charge pendant l'intervalle de temps qui lui est imparti au cours des commutations et cette charge est maintenue pendant le reste du temps. En régime établi, chaque capacité rejoint la valeur du signal à laquelle elle est sollicitée. En sortie du filtre, le signal obtenu est une forme approchée du signal d'entrée, par valeurs discrètes, régulièrement réparties. Les caractéristiques du filtre passe-bande ainsi réalisé et représenté sur la figure sont déterminées par les éléments du filtre passe-bas constitué par chaque cellule de chaque chemin. La sélectivité ou la bande passante de ce filtre à $n$ chemins commutés dépend bien entendu du nombre $n$. L'effet de l'échantillonnage sur les cellules de filtrage passe-bas de chaque chemin produit en fait, non pas une seule réponse passe-bas centrée sur la fréquence fondamentale $f_0$ du signal d'entrée, mais toute une série de bandes centrées sur les harmoniques de la fréquence $f_0$

et sur la fréquence 0.

Comme on le verra par la suite, la forme générale de la réponse de ce filtre à commutation à $n$ chemins est caractéristique de l'échantillonnage. En particulier, si $n$ est le nombre de chemins, le système a une réponse nulle pour les fréquences $nf_0$, $2nf_0$, etc..., c'est pour cette raison que ces filtres sont souvent appelés filtres en peigne et que l'on désigne par dents du peigne les raies centrées sur les fréquences $f_0$, $2f_0$, etc...

En référence à la figure 1, on a représenté en b) un schéma équivalent du filtre à commutation de type « série », précédent. Sur ce schéma équivalent, la résistance d'entrée $R_e'$ est la résistance équivalente à la résistance d'entrée $R_e$ et à la résistance R de chacun des chemins ; le filtre équivalent ainsi obtenu est bien un filtre de type « série » puisque les portes ou commutateurs d'échantillonnage $l_1$ et $l_2$ sont disposés entre l'entrée E et la sortie S du signal. Cette disposition a pour principal avantage de placer les résistances de passage des commutateurs $l_1$ et $l_2$ de chaque chemin, en série avec l'élément purement résistif $R_e'$ et de conserver à l'élément C son caractère purement réactif. Les commutateurs $l_1$ et $l_2$ peuvent être actionnés, soit simultanément, soit avec un certain décalage fixe dans le temps. Il en résulte alors un déphasage fixe à la sortie ; seule cette disposition de type « série » permet ce déphasage.

Le filtre à commutation à $n$ chemins de type série qui vient d'être décrit sur les figures 1a et 1b peut être qualifié de filtre en peigne ; il peut être facilement transformé en filtre à commutation de $n$ chemins, de type passe-bande, lorsqu'il est suivi d'un filtre passe-bande grossier, suffisant pour ne favoriser que l'une des raies du peigne.

Toujours sur la figure 1, on a représenté en c), un filtre à commutation à $n$ chemins, de type « shunt », connu dans l'état de la technique ; le schéma de ce filtre est tiré du schéma équivalent du filtre à structure série de la figure 1b. Sur le schéma équivalent de la figure 1b, on voit que si l'on ne désire pas introduire de déphasage entre les signaux d'entrée et de sortie du filtre, l'un des commutateurs $l_1$ ou $l_2$ peut être supprimé dans chacun des chemins et peut être remplacé par un commutateur unique I, commandable, qui permet de relier successivement et périodiquement chacun des condensateurs C avec la résistance d'entrée $R_e'$. Le filtre à structure « shunt » représenté sur la figure 1c présente un montage plus économique, mais il ne permet pas comme le filtre à structure « série » d'introduire un déphasage entre les signaux de sortie et les signaux d'entrée.

Dans les filtres à structure « série » ou à structure « shunt » qui viennent d'être décrits, les commutateurs sont de type analogique ; ils réalisent une fonction porte analogique et sont généralement constitués par des transistors à effet de champ qui sont, soit bloqués, soit saturés, en fonction des signaux de commutation qui sont appliqués à leur grille.

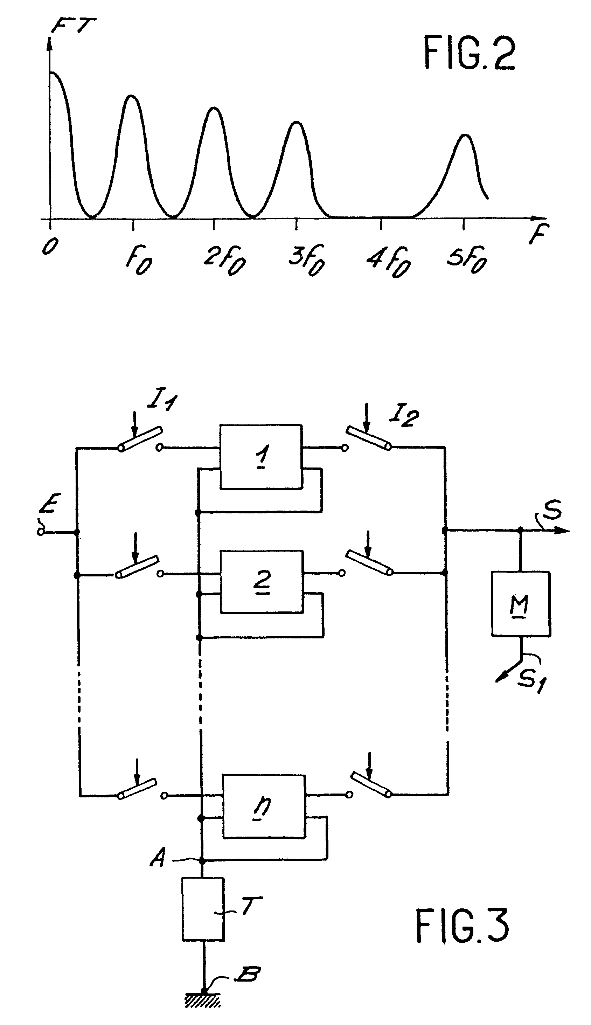

En référence à la figure 2, on a représenté un diagramme illustrant la fonction de transfert $F_T$ de l'un des filtres précédents, en fonction de la fréquence $f$ du signal parvenant à l'entrée de ce filtre. Comme on l'a expliqué précédemment, les filtres décrits sur les figures précédentes sont des filtres passe-bande, dits en « peigne », pour lesquels la fonction de transfert résultante est symétrique par rapport à la fréquence de commutation $f_0$. L'une des originalités de ces filtres est que si l'on change la fréquence $f_0$ de commutation, on change la fréquence centrale du filtre passe-bande à $n$ chemins commutés, sans changer la largeur de la bande. Cependant, comme on l'a déjà indiqué, la dénomination de filtre en peigne vient du fait que l'échantillonnage produit non pas une seule réponse passe-bande centrée sur $f_0$, mais toute une série de bandes centrées sur les harmoniques de $f_0$ et la fréquence 0, comme le montre la figure 2. La fonction de transfert représenté sur la figure 2 est caractéristique d'un filtre échantillonné, à quatre chemins. Les dents du peigne désignent les raies en $f_0$, $2f_0$, etc... La durée relative des échantillonnages n'est pas critique. C'est la somme des durées de ces échantillons qui doit être strictement égale à la période $T_0$ du fondamental du signal d'entrée, sous peine d'élargissement de la raie à la fréquence $f_0$.

Les filtres à commutation qui viennent d'être décrits et qui sont connus dans l'état de la technique, ont pour principal inconvénient de restituer un signal qui n'est qu'une approximation par valeurs discrètes, du signal d'entrée. Ce signal restitué est chargé d'harmoniques qui n'existent pas à l'entrée du filtre. Pour supprimer ces harmoniques, il est nécessaire de placer en sortie du filtre à commutation un filtre passe-bas dont les caractéristiques de transfert et de phase se superposent à celles du filtre à commutation et en réduisent parfois l'intérêt. Ces filtres à commutation doivent présenter un signal de commande des commutations dont la fréquence est nettement plus élevée que l'harmonique de plus haut rang à analyser. Le signal qui pilote ces commutations est un signal logique dont la fréquence détermine la fréquence des raies du peigne.

Comme on l'a indiqué précédemment, il est connu de déplacer ces raies et en particulier de poursuivre le signal d'entrée, soit en prélevant un signal de synchronisation des commutations en amont du filtre, soit en prélevant un signal de synchronisation des commutations en aval du filtre. Si le signal de synchronisation est prélevé en amont du filtre, les commutations sont commandées par l'intermédiaire d'un filtre passe-bande qui reçoit le signal d'entrée et qui commande un multiplieur par $n$. Si la plage de poursuite est très étendue, le filtre passe-bande doit présenter une très large bande, ce qui risque de provoquer une agitation en phase très importante à la sortie du filtre à commutation. Il en résulte que le filtre passe-bande commandant le multiplieur doit être un filtre assez sélectif qui réduit beaucoup la plage de poursuite du filtre à commutation. Un filtre à commutation à poursuite amont ne peut donc être utilisé que pour des signaux périodiques dont la fréquence s'écarte peu d'une valeur déterminée.

Comme on l'a déjà indiqué plus haut, il est préférable de prélever le signal de synchronisation des commutations en aval du filtre suiveur à commutation. Dans ce cas, ce signal est prélevé en aval du filtre, par l'intermédiaire d'un filtre passe-bas dont la fréquence de coupure est par exemple aussi élevée que $nf_0$. Ce filtre passe-bas commande un multiplieur dont les sorties commandent les commutations de $n$ chemins. Cependant, lorsqu'un signal utile se présente à l'entrée d'un tel filtre, il ne se retrouve pas en sortie ; il est nécessaire de prévoir d'une part la capture du signal d'entrée, et, d'autre part, sa poursuite lorsque la fréquence de ce signal varie. En effet, si la capture du signal d'entrée est réalisée sur un signal de fréquence $f$ déterminée, il faut en cas de variation de $f$, que cette variation se retrouve assez tôt en sortie du multiplieur avant que la fréquence $f$ ne sorte de la bande passante du filtre à commutation. Si cette condition n'est pas réalisée, le filtre à commutation revient à son état initial ; il est donc nécessaire de prévoir la poursuite du signal d'entrée. Différents systèmes de capture et de poursuite du signal d'entrée, par synchronisation aval sont connus. Pour qu'il y ait capture, il faut et il suffit qu'à un moment donné la fréquence à poursuivre apparaisse en sortie du filtre à commutation, avec un niveau suffisant pour exciter le multiplieur. Parmi les différents systèmes de capture connus, on peut citer les suivants :

— la capture par rampe : dans la période d'attente qui précède l'apparition du signal de fréquence $f$ à l'entrée du filtre, le multiplieur est excité par une fréquence variable qui balaye, en suivant une rampe, toute la plage de capture. Quand la fréquence des commutations du filtre coïncide avec la fréquence $f$ du signal d'entrée, le filtre capture le signal et il est alors possible de débrancher le générateur de rampe ;

— la capture par réseau de filtres : dans un tel système, plusieurs filtres à commutation sont disposés en parallèle et sont attaqués par le même signal d'entrée. Leurs fréquences centrales sont décalées d'une largeur de bande de filtrage. Parmi tous ces filtres disposés en parallèle, au moins l'un d'eux capture le signal d'entrée et permet de le poursuivre ;

— la capture par mesure de phase : on sait qu'un filtre à commutation ne déphase pas la fréquence sur laquelle il est centré. Il est donc possible de prévoir un système qui se débranche lorsque la phase s'annule, c'est-à-dire lorsque la capture du signal d'entrée est effective.

Il existe d'autres filtres présentant des systèmes connus de capture qui ne seront pas décrits en détail ; comme les systèmes mentionnés plus haut, ils ont pour inconvénient de ne pas permettre, outre la capture du signal d'entrée, la poursuite de ce signal lorsque sa fréquence varie dans de très larges proportions. De plus, tous les systèmes qui viennent d'être décrits nécessitent des circuits annexes qui augmentent considérablement le coût de fabrication des filtres à commutation.

En référence à la figure 3, on a représenté schématiquement un filtre suiveur à commutation, à n chemins, de type « série », conforme à l'invention et incluant une impédance permettant de modifier la fonction de transfert du filtre ; ce filtre suiveur à commutation présente deux séries de commutateurs, tels que $I_1$ et $I_2$, disposés de part et d'autre des cellules de filtrage de chaque chemin ; ces cellules de filtrage sont représentées sur la figure sous forme de quadripôles 1, 2...n, qui comprennent au moins un élément réactif, et dont certains exemples seront décrits plus loin en détail. Ce filtre suiveur comprend également des moyens de commande M qui permettent de prélever en aval du filtre, du côté de la sortie S de celui-ci, un signal de synchronisation des commutations des n chemins ; ces moyens de commande des commutations délivrent sur leur sortie $S_1$ des signaux de commande de fermeture ou d'ouverture des commutateurs $I_1$ et $I_2$ de chaque chemin ; il est bien évident que les commutateurs $I_1$ et $I_2$ peuvent être de type électronique et être constitués par exemple, par des transistors à effet de champ présentant, soit un état bloqué, soit un état saturé. Des moyens T, constitués par un dipôle, inséré entre le point commun A à tous les quadripôles, et un point B porté à un potentiel de référence, permettent de modifier la fonction de transfert du filtre, de façon à laisser passer en sortie de ce filtre une partie du signal arrivant à l'entrée E de celui-ci. Comme on le verra plus loin en détail, ce dipôle est une impédance qui comprend, par exemple, une résistance connectée en parallèle avec un condensateur. La présence de cette impédance modifie la fonction de transfert du filtre à commutation ; cette fonction de transfert se superpose à celle du dipôle. Cette modification de la fonction de transfert du filtre sera décrite plus loin en détail. La présence de cette impédance permet au filtre à commutation à n chemins, de capturer le signal d'entrée lorsque la fréquence fondamentale de celui-ci varie dans de très larges proportions. L'impédance est ici reliée en série avec l'ensemble des éléments réactifs des n chemins.

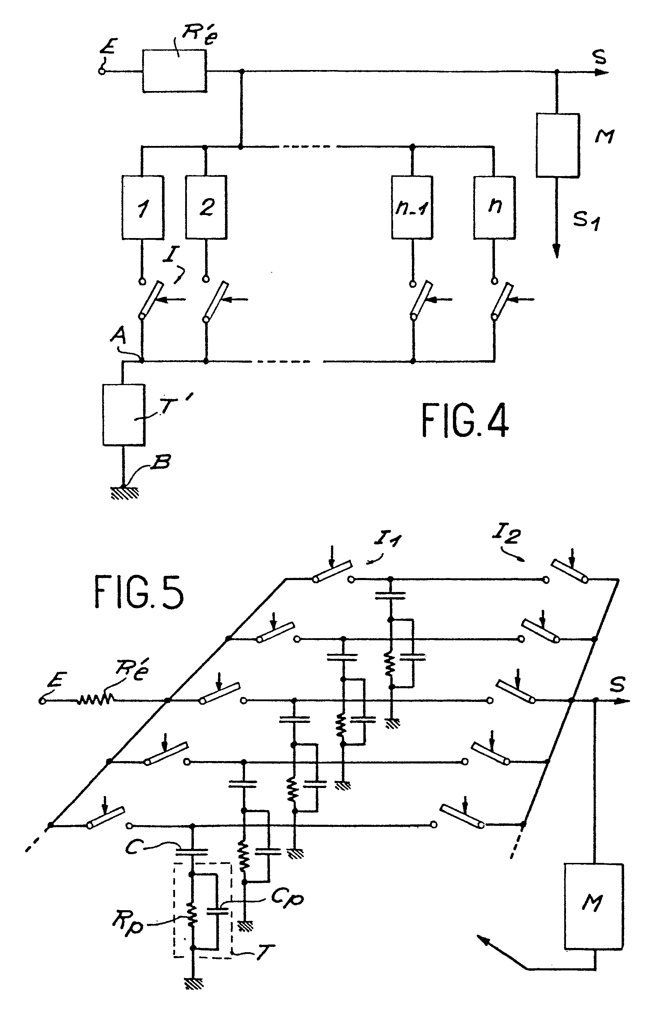

En référence à la figure 4, on a représenté schématiquement un filtre suiveur à commutation à n chemins, de type « shunt » conforme à l'invention et incluant une impédance T′ permettant de modifier la fonction de transfert du filtre. Cette impédance est reliée en série avec l'ensemble des cellules de filtrage 1, 2 ... n-1, n des n chemins. Elle est située entre le point A commun à tous les dipôles constituant les cellules de filtrage des différents chemins et un point B porté à un potentiel de référence. Comme on l'a vu plus haut, dans cette structure « shunt », chaque chemin ne comprend qu'un seul commutateur situé en sortie de chaque cellule de filtrage. La référence $R_e′$ désigne une résistance commune à l'ensemble des chemins ; comme précédemment, des moyens M permettent de prélever un signal de synchronisation, en aval du filtre, du côté de la sortie S de celui-ci ; ces moyens commandent par leur sortie $S_1$ les commutations des différents chemins ; bien entendu, les commutateurs I peuvent être constitués par des transistors à effet de champ qui, recevant les signaux de commande fournis par les moyens M, passent successivement, soit à l'état bloqué, soit à l'état saturé. Les moyens T′ qui permettent de modifier la fonction de transfert du filtre et qui ne sont pas représentés ici en détail, sont constitués par une impédance comprenant, par exemple, une résistance connectée en parallèle avec un condensateur. Comme précédemment, la présence de cette impédance modifie la fonction de transfert de l'ensemble de sorte que la fonction de transfert du filtre à commutation se superpose à la fonction de transfert de cette impédance. Comme on le verra plus loin en détail, cette impédance permet d'assurer la capture et la poursuite du signal d'entrée E, même si la fréquence de ce signal varie dans de très larges proportions.

Dans le filtre qui vient d'être décrit à l'aide des figures 3 et 4, on dira que l'impédance qui permet de modifier la fonction de transfert du filtre donne à celui-ci une possibilité de capture « par pied », « non échantillonnée » puisque cette impédance est commune à l'ensemble des chemins dans ces deux figures.

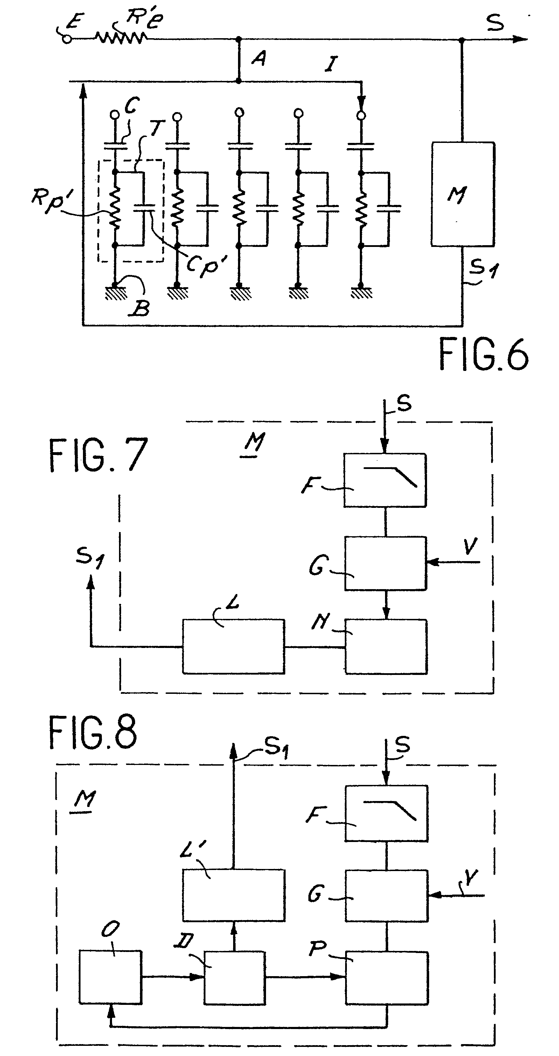

En référence à la figure 5, on a représenté schématiquement un filtre suiveur à commutation à n chemins, de type « série », incluant une boucle de commande de synchronisation « aval » des commutations des chemins ; dans le filtre représenté sur cette figure, une impédance T permettant de modifier la fonction de transfert du filtre est reliée en série avec l'élément réactif C de chacun des chemins. Cette impédance T est constituée par une résistance $R_p$, connectée en parallèle avec un condensateur $C_p$. La boucle de commande de synchronisation comprend des moyens de commande M qui permettent de prélever un signal de synchronisation en aval du filtre à commutation, du côté de la sortie S de celui-ci, de manière à commander l'ouverture ou la fermeture des commutateurs tels que $I_1$ et $I_2$, des différents chemins. On a également représenté sur cette figure une résistance d'entrée $R_e′$, commune à l'ensemble des chemins et disposée à l'entrée E du filtre. Les moyens M seront décrits plus loin en détail. La fonction de transfert de chacun des chemins est modifiée par la présence de l'impédance T ; le résultat de cette modification sur la fonction de transfert globale du filtre suiveur à commutation est telle que dans la bande de capture souhaitée, le module de la fonction de transfert n'est jamais nul et sa valeur est suffisante pour assurer la synchronisation des moyens de commande des commutations.

En référence à la figure 6, on a représenté schématiquement un filtre suiveur à commutation à n chemins, de type « shunt », incluant des moyens M pour prélever en aval du filtre, du côté de la sortie S de celui-ci, un signal de synchronisation et de commande des commutations des chemins. Dans le filtre représenté sur cette figure, une impédance T' modifiant la fonction de transfert du filtre est reliée en série avec l'élément réactif C de chacun des chemins ; cette impédance T', constituée par une résistance $R_p'$ connectée en parallèle avec un condensateur $C_p'$, est située entre l'élément réactif C et un point B porté à un potentiel de référence. Les moyens de commande M provoquent la fermeture ou l'ouverture des commutateurs I ; comme précédemment, dans toute structure « shunt », une résistance $R_e'$, commune à l'ensemble des chemins, est connectée entre l'entrée E du filtre et le point A, commun à l'ensemble des chemins. L'impédance T' permet de modifier la fonction de transfert de chacun des chemins, de sorte que le module de la fonction de transfert globale du filtre n'est jamais nul et que sa valeur est suffisante pour assurer la synchronisation du circuit de commande des commutations.

Les filtres qui viennent d'être décrits en regard des figures 5 et 6 présentent une impédance en série avec l'élément réactif de chaque chemin et sont qualifiés ici de filtres suiveurs à commutation à $n$ chemins, avec capture du signal d'entrée, par « pied échantillonné ».

En référence à la figure 7, on a représenté un premier mode de réalisation des moyens de synchronisation et de commande M, qui permettent de prélever un signal synchrone du signal d'entrée, en aval du filtre, et de commander les commutations. Dans ce mode de réalisation, les moyens M comprennent éventuellement un amplificateur G. Le signal de sortie S du filtre à commutation parvient à cet amplificateur à travers un filtre passe-bas F. Il est suivi d'un multiplicateur N, qui permet de multiplier la fréquence du signal reçu de l'amplificateur par le nombre $n$ des commutations. Ce multiplicateur est relié à un ensemble logique L permettant de décoder les signaux de sortie du multiplicateur et de commander par des signaux de sortie $S_1$ les commutations des différents chemins dans les filtres suiveurs de type « série » ou « shunt », conformes à l'invention.

En référence à la figure 8, on a représenté un mode de réalisation particulier du multiplicateur N. Ce mode de réalisation particulier comporte une boucle à verrouillage de phase. Cette boucle comprend un filtre passe-bas F qui reçoit le signal de sortie du filtre à commutation et éventuellement un amplificateur G ; un phase-mètre P reçoit, d'une part, le signal de sortie de ce filtre passe-bas, et, d'autre part, le signal de sortie d'un diviseur D qui permet de diviser par $n$ la fréquence du signal de sortie d'un oscillateur 0 ; cet oscillateur est asservi par le signal de sortie du phase-mètre P, à osciller sur une fréquence égale à $n$ fois celle de la composante utile du signal d'entrée du filtre à commutation. L'état du diviseur D se modifie donc avec cette fréquence qui est $n$ fois supérieure à celle de cette composante utile du signal d'entrée. Le diviseur D est relié à un circuit logique L' ; les signaux de sortie $S_1$ de ce circuit logique commandent les commutateurs des différents chemins des filtres suiveurs de type « shunt » ou de type « série », conformes à l'invention.

Les moyens de commande qui viennent d'être décrits en regard des figures 7 et 8 permettent aux filtres suiveurs de l'invention de suivre les variations de fréquence du signal d'entrée à filtrer ; la capture de ce signal est en effet assurée grâce à l'impédance qui a été décrite plus haut, disposée dans chacun des chemins ou commune à l'ensemble des chemins.

Selon un perfectionnement de l'invention, l'amplificateur G peut être du type à commande automatique de gain, connu dans l'état de la technique. Cet amplificateur est sensible à toute différence entre le niveau de son signal de sortie et un niveau constant V, de sorte qu'une réaction intervient sur le gain de l'amplificateur pour annuler cette différence. Cet amplificateur présente un gain très élevé à niveau d'entrée nul et il permet un accrochage des commutations sur la fréquence de la composante utile du signal d'entrée. Dès que l'accrochage est effectué, le gain de G diminue fortement.

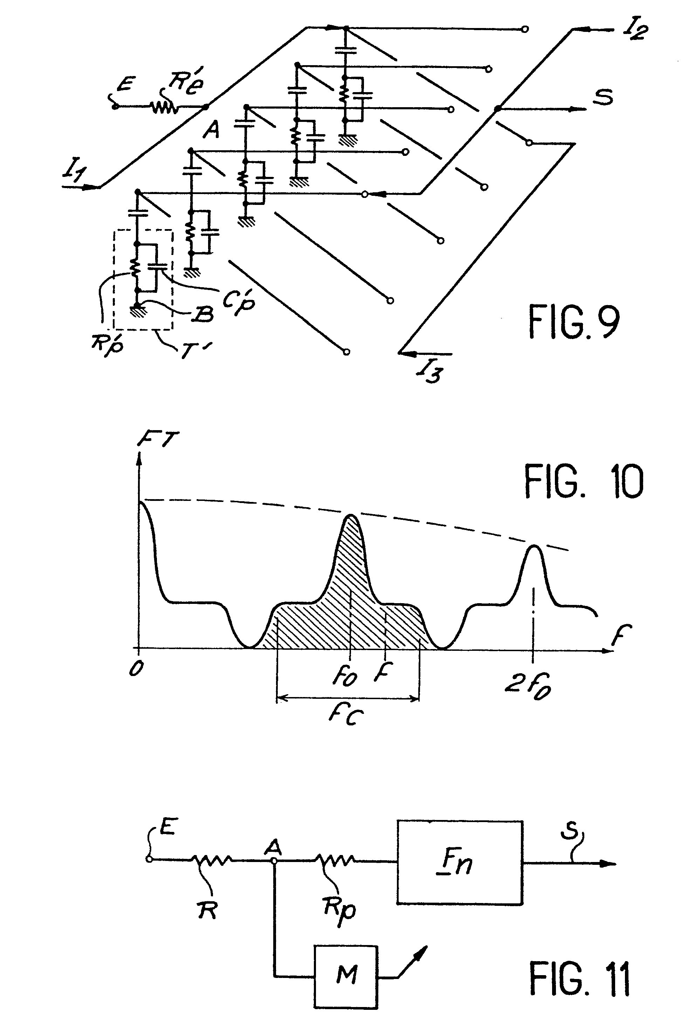

En référence à la figure 9, on a représenté schématiquement un autre mode de réalisation d'un filtre suiveur à commutation de $n$ chemins, conforme à l'invention. Dans ce mode de réalisation, des moyens permettent de déphaser les signaux de commande des commutations, par rapport au signal synchrone du fondamental du signal d'entrée, de façon à obtenir, en sortie du filtre, un signal déphasé par rapport au signal d'entrée.

On a vu précédemment que seul un filtre à commutation, de type « série » permet de réaliser des déphasages entre le signal de sortie et le signal d'entrée, en commandant chacun des commutateurs $I_1$ et $I_2$, indépendamment. Il est donc possible de réaliser des filtres suiveurs à synchronisation « aval » de type « série », mais dans ce cas cependant, seul un filtre suiveur incluant une impédance connectée en série et commune avec tous les chemins est utilisable ; ceci correspond, comme on l'a expliqué plus haut, à un filtre suiveur de type « série » à « pied non échantillonné ». Un filtre suiveur selon l'invention, incluant une impédance dans chacun des chemins et permettant de modifier la fonction de transfert du filtre tout en gardant une possibilité de déphasage du signal de sortie par rapport au signal d'entrée est représenté sur la figure 9. Ce filtre comprend une résistance d'entrée $R_e'$ connectée entre l'entrée E du filtre et un point A commun à l'ensemble des chemins. Chaque chemin comprend, comme précédemment, un condensateur C qui, associé à la résistance $R_e'$, constitue la cellule de filtrage correspondant à ce chemin. Une impédance T', constituée par une résistance $R_p'$ est connectée en parallèle avec un condensateur $C_p'$ et permet, comme on l'a vu plus haut, de modifier la fonction de transfert de chaque chemin. Cette impédance est bien entendu connectée entre le condensateur C et le potentiel de référence B. Ce filtre comprend trois

séries de commutateurs $I_1$, $I_2$, $I_3$, et il fonctionne de la manière suivante : la série de commutateurs $I_3$ est disposée en parallèle avec la série de commutateurs $I_2$ ; les commutateurs $I_3$ sont commandés par des signaux synchrones des signaux de commande des commutateurs $I_1$ et $I_2$, mais décalés de la valeur nécessaire au déphasage recherché entre le signal de sortie S du filtre et le signal d'entrée E. On n'a pas représenté sur cette figure les moyens qui permettent de commander les différents commutateurs et de prélever à la sortie S du filtre un signal synchrone du signal d'entrée. Ces moyens ont été décrits plus haut en détail.

La figure 10 est un diagramme représentant la fonction de transfert $F_T$ des filtres suiveurs à commutation, conformes à l'invention, tels que décrits en regard des figures 3 à 9. Comme on l'a indiqué plus haut, l'invention consiste à introduire dans l'ensemble des chemins du filtre ou sur chacun de ces chemins, une impédance permettant de modifier la fonction de transfert globale du filtre, de façon à laisser passer en sortie de celui-ci une partie du signal d'entrée. Cette impédance favorise la capture du signal d'entrée du filtre dans le cas où la fréquence de ce signal varie dans de très larges proportions. Cette capture a été qualifiée de « capture par pied ». La fonction de transfert $F_T$ du filtre conforme à l'invention, en fonction de la fréquence f, fait apparaître un piédestal en regard de chaque dent du peigne. Ce piédestal est dû à la présence de l'impédance reliée en série avec chaque chemin ou avec l'ensemble des chemins du filtre. Comme le montre la figure qui représente le cas d'un filtre comportant une impédance dans chaque chemin, une partie du signal d'entrée passe en sortie du filtre ; le piédestal est limité à la bande de poursuites $f_c$, autour de la fréquence fondamentale $f_0$ du signal d'entrée. En l'absence de signal d'entrée, le filtre à commutation équipé de moyens de commande des commutations précédemment décrits, se positionne sur $f_0$, au milieu de la plage de capture. Lorsqu'un signal d'entrée de fréquence f à capturer se présente à l'entrée du filtre, une partie de ce signal se retrouve en sortie grâce au « pied ». Le filtre à commutation se centre sur la fréquence f en laissant passer la totalité du signal. Ce processus de capture n'est pas immédiat car les moyens de commande des commutations ne sont excités, au départ, que par un signal de faible amplitude, affecté de bruit ; il faut donc un certain temps pour charger les condensateurs du filtre. On voit, sur cette figure, que grâce à la modification de la fonction de transfert du filtre, le signal présent à l'entrée du filtre et dont la fréquence peut varier, passe bien pour toutes les fréquences et en particulier pour les fréquences de la plage de capture ; la composante fondamentale du signal d'entrée passe en totalité aux emplacements des dents du peigne.

Si l'on utilise la disposition particulière décrite en référence aux figures 7 et 8 (amplificateur G à commande automatique de gain), le piédestal représenté en figure 10 présente une hauteur variable en cours de fonctionnement, importante pendant la phase de capture du signal d'entrée, très réduite pendant la phase de poursuite, pendant laquelle la fonction de transfert du filtre n'est ainsi nullement perturbée par le dispositif de capture.

En référence à la figure 11 on a représenté un autre mode de réalisation d'un filtre conforme à l'invention dans lequel le signal préfiltré qui permet de synchroniser les commutations, est prélevé en un point du filtre tel que la partie du signal d'entrée qui subsiste dans le signal de sortie de ce filtre est minimisée par rapport à la partie du signal d'entrée qui figure dans le signal préfiltré. Dans ce mode de réalisation, la fonction de transfert du filtre $F_n$ à $n$ chemins, de type « série » ou « shunt », est modifiée de manière à ne laisser passer une partie du signal d'entrée et donc des bruits de fond, vers la sortie de ce filtre, que sur la voie de synchronisation des commutations ; la voie destinée au traitement du signal d'entrée n'est pas affectée. Sur cette figure les moyens qui permettent de prélever un signal de synchronisation des chemins sont représentés en M. La sortie du filtre est désignée par S tandis que son entrée est désignée par E. Les défauts acceptés pour parvenir à une synchronisation automatique ne se retrouvent que sur la voie de commande de synchronisation. La résistance $R_p$ qui permet d'obtenir le pied de capture, dans ce mode de réalisation, est disposée en série à l'entrée du filtre, avec une résistance commune R. La fonction de transfert sur la voie de traitement du signal d'entrée qui comporte le filtre suiveur $F_n$ à $n$ chemins de type « série » ou « shunt », n'est pas affectée par la présence de la résistance $R_p$. Cette fonction de transfert dépend seulement de la somme des valeurs des résistances R et $R_p$ ; les valeurs de ces résistances peuvent être ajustées indépendamment. Quel que soit l'état du filtre, on observe sur la sortie S de celui-ci, une fonction de transfert qui n'est pas modifiée, qui présente une configuration en peigne extrêmement sélective, caractéristique du filtre à $n$ chemins. En A, au point commun aux résistances R et $R_p$, cette fonction de transfert n'est pas la même et comporte un « pied » dû à la présence de $R_p$ en aval de A. En A, on retrouve la fonction de transfert global du filtre à $n$ chemins, modifiée ; à tout moment on retrouve aussi une partie du signal d'entrée et du bruit d'entrée. C'est cette partie du signal d'entrée qui est utilisée dans la voie de synchronisation des chemins, pour assurer la capture et la poursuite, comme dans les modes de réalisation précédents.

Sur la voie de synchronisation M, la part de bruit acceptée pour assurer la fonction de capture et de poursuite en fréquence, n'a plus besoin d'être limitée avec autant de soins que dans les autres modes de réalisation. En effet, dans le mode de réalisation qui comporte une boucle à verrouillage de phase, les inconvénients dus à la présence du bruit, sont limités à la plage de capture elle-même (effet rejecteur de bruit de la boucle à verrouillage de phase).

Il est évident que cette part du bruit affecte le comportement de la voie de synchronisation et produit sur le signal de synchronisation numérique, une gigue de phase. Cette gigue de phase crée une incertitude équivalente sur la position des dents du peigne, sur l'axe des fréquences, mais contrairement aux modes de réalisation précédents, la fonction de transfert du filtre, quoique agité en fréquence, conserve ses caractéristiques. Dans ce mode de réalisation, la conception du filtre est simplifiée et le résultat obtenu est équivalent et même meilleur que celui qui est obtenu dans le cas d'un pied échantillonné. Le pied échantillonné est lui-même une amélioration du pied simple, commun aux $n$ chemins.

La résistance $R_p$ est commune aux N chemins et reste maîtrisable. En effet, on peut l'ajuster ou la supprimer par des moyens simples.

Selon un autre mode de réalisation non représenté et qui correspond sensiblement au montage de la figure 9, un troisième commutateur à $n$ positions ou pas supplémentaires, commandé par un signal propre de fréquence nf', permet d'explorer successivement l'état des $n$ chemins. On obtient ainsi sur une voie séparée de la voie de traitement du signal d'entrée, un signal de même forme que le signal de sortie de la voie de traitement du filtre à $n$ chemins commutés, avant l'adjonction de ce commutateur supplémentaire. La fréquence de ce signal sur cette voie séparée peut être soit proportionnelle à la fréquence du signal d'entrée (multiple ou sous-multiple), soit proportionnelle à une fréquence fixe. Dans le cas d'une fréquence proportionnelle à la fréquence du signal d'entrée, on réalise un multiplieur ou un diviseur de fréquences par un nombre entier pair ou impair, fractionnaire ou quelconque, tout en conservant la forme de ce signal sans autre distorsion que celle qui est apportée par le nombre limité des chemins. Dans le cas d'une sortie à fréquence fixe, on récupère la forme du signal d'entrée en s'affranchissant des fluctuations en fréquence (gigue de phase), ce qui présente un intérêt important dans le domaine de la synthèse des signaux périodiques complexes ou dans le domaine de la reconnaissance de la forme d'un signal. En effet, lorsqu'il est débarrassé de sa gigue de phase, le signal peut être comparé très précisément à un signal de référence produit à la même fréquence f' et le pouvoir de discrimination est accru. Le signal est non seulement débarrassé de sa gigue de phase, mais il est également possible d'agir sur sa phase pour l'amener en coïncidence avec celle du générateur de référence qui délivre des signaux à fréquence fixe connue.

A la sortie d'un filtre suiveur, le signal est par nature, à fréquence variable. Il en résulte des difficultés pour son exploitation et plusieurs cas peuvent se présenter :

— On peut exploiter le signal directement sous sa forme temporelle. Comme le phénomène n'est pas stationnaire, l'inscription du signal de manière non volatile, sur un support d'enregistrement graphique par exemple, pose des problèmes de distorsion : l'axe des temps n'est plus en relation avec la période.

— On peut également exploiter le résultat du filtrage, en passant dans le domaine fréquentiel, par exemple à l'aide d'une transformation de Fourier. Comme la réponse n'est pas à fréquence fixe, il s'ensuit un « flou » ou des « traînages », qui rendent parfois l'exploitation difficile ou impossible.

Une sortie à fréquence fixe résout ces deux problèmes d'exploitation. Ceci permet de résoudre notamment le problème de la reconnaissance de signaux périodiques noyés dans un bruit de fond.

Par ailleurs, dans les différents modes de réalisation du filtre suiveur à commutation conforme à l'invention, qui viennent d'être décrits, le « pied » échantillonné ou non peut être modifié ou supprimé au cours du fonctionnement du filtre en agissant sur la ou les impédances qui permettent de modifier la fonction de transfert du filtre. On peut par exemple substituer à la résistance, ou aux résistances de chacune de ces impédances, une ou des résistances ajustables électriquement. Ces résistances ajustables peuvent être des transistors à effet de champ, des cellules photorésistantes, des potentiomètres d'asservissement ou encore des résistances simulées avec des commutateurs et des capacités. Cette dernière disposition présente l'avantage d'être facilement intégrable. Les valeurs de ces résistances ajustables peuvent éventuellement être annulées, lorsque le rapport signal sur bruit est important.

**Revendications**

1. Filtre suiveur à commutation à $n$ chemins, de type passe-bande à bande étroite, comportant dans chaque chemin un élément réactif (C) situé dans une branche transversale du chemin respectif, reliée d'une part à un potentiel de référence et d'autre part, à un point du chemin disposé entre l'entrée (E) et la sortie (S) du filtre, chaque chemin étant commuté par l'intermédiaire d'au moins un commutateur (I, $I_1$, $I_2$) commandé par des moyens (M) de commande d'ouverture et de fermeture prélevant à la sortie (S) du filtre un signal de synchronisation des commutations des $n$ chemins, caractérisé en ce que ladite branche transversale comporte entre le potentiel de référence et le point situé sur le chemin entre l'entrée (E) et la sortie (S) du filtre une impédance de modification (T) branchée en série avec l'élément réactif (C) lorsque le commutateur associé au chemin est fermé modifiant ainsi, en raison de son dimensionnement, la fonction de transfert du filtre de telle façon qu'avant la capture du signal d'entrée à fréquence variable une partie de l'amplitude de ce signal d'entrée subsiste en sortie du filtre.

2. Filtre selon la revendication 1, caractérisé en ce que chaque branche transversale contient une impédance de modification (T) distincte.

3. Filtre selon la revendication 1, caractérisé en ce que les branches transversales sont reliées à un point commun et que l'impédance de modification (T), commune à tous les chemins, est branchée entre ce point et le potentiel de référence.

4. Filtre suiveur à commutation selon l'une quelconque des revendications 2 et 3, caractérisé en ce que ladite impédance de modification comprend une résistance connectée en parallèle avec un condensateur.

5. Filtre suiveur à commutation selon l'une quelconque des revendications 2 et 3, caractérisé en ce que ladite impédance comprend une résistance réglable, connectée en parallèle avec un condensateur.

6. Filtre suiveur à commutation, selon l'une quelconque des revendications 2 et 3, caractérisé en ce qu'il comprend des moyens pour supprimer ladite impédance en cours de fonctionnement du filtre.

7. Filtre suiveur à commutation selon l'une quelconque des revendications 1 à 6, caractérisé en ce que les moyens de commande (M) d'ouverture et de fermeture comprennent un amplificateur à commande automatique de gain, connecté en sortie du filtre, de manière à amplifier le signal de synchronisation prélevé sur cette sortie.

8. Filtre suiveur à commutation selon l'une quelconque des revendications 4 à 7, caractérisé en ce que chaque chemin comprend un autre commutateur ($I_2$) commandé par les moyens de commutation (M), l'un des commutateurs ($I_1$) mettant ce chemin en communication avec l'entrée, l'autre ($I_2$) le mettant en communication avec la sortie, le filtre comportant en outre, connectés en parallèle sur les commutateurs de sortie, un jeu de commutateurs, et des moyens pour déphaser les signaux de commande des commutateurs de ce jeu, par rapport aux signaux de commande des commutateurs d'entrée et de sortie.

9. Filtre suiveur à commutation selon l'une quelconque des revendications 4 à 7, caractérisé en ce que chaque chemin comprend un autre commutateur ($I_2$) commandé par les moyens de commutation (M), l'un des commutateurs ($I_1$) mettant ce chemin en communication avec l'entrée, l'autre ($I_1$) le mettant en communication avec la sortie, le filtre comportant en outre connectés en parallèle sur les commutateurs de sortie, un jeu de commutateurs, et des moyens pour commander les commutateurs de ce jeu, à fréquence fixe.

10. Filtre suiveur à commutation selon l'une quelconque des revendications 4 à 7, caractérisé en ce que chaque chemin comprend un autre commutateur ($I_2$) commandé par les moyens de commutation (M), l'un des commutateurs ($I_1$) mettant ce chemin en communication avec l'entrée, l'autre ($I_2$) le mettant en communication avec la sortie, le filtre comprenant en outre, connectés en parallèle avec les commutateurs de sortie, un jeu de commutateurs, et des moyens pour commander les commutateurs de ce jeu à une fréquence proportionnelle à la fréquence du signal d'entrée.

## Claims

1. N-channel frequency-tracking filter of the band-pass type with narrow bands, having in each channel a reactive element (c) located in a transverse branch of its respective channel, connected on the one hand to a reference potential, and on the other hand to a point on the channel located between the input (E) and the output (S) of the filter, each channel being commutatable by means of a switch ($I_1I_1$, $I_2$) commanded by means (M) for commanding opening and closing delivering at the output (S) of the filter a synchronization signal for switching of the N-channels, characterized in that said transverse branch has, between the reference potential and the point located between the input (E) and the output (S) of the filter, a modifying impedance (T) branched in series with the reactive element (C) when the switch associated with the respective channel is closed, thereby modifying (as a result of its parameters) the transfer function of the filter whereby, before capture of the variable-frequency input signal, a part of the amplitude of the input signal exists at the output of the filter.

2. Filter according to claim 1, characterized in that each transverse branch comprises a separate modifying impedance (T).

3. Filter according to claim 1, characterized in that the transverse branches are connected to a common point, and in that a modifying impedance (T), common to all the channels is branched between that point and the reference potential.

4. Frequency-tracking filter according to either one of claims 2 and 3, characterized in that said modifying impedanoe comprises a resistance connected in parallel with a condensor.

5. Frequency-tracking filter according to either one of claims 2 and 3, characterized in that said impedance comprises a rehostat connected in parallel with a condensor.

6. Frequency-tracking filter according to either one of claims 2 and 3, characterized in that it comprises means for suppressing said impedance during functioning of the filter.

7. Frequency-tracking filter according to any one of claims 1 to 6, characterized in that the means (M) for commanding opening and closing comprise an automatic gain control amplifier connected at the filter output whereby to amplify the synchronization signal delivered at said output.

8. Frequency-tracking filter according to any one of claims 4 to 7, characterized in that each channel comprises a second switch ($I_2$) commanded by the command means (M), the first of the switches ($I_1$) putting the channel in communication with the input, the other ($I_2$) putting it in

communication with the output, the filter additionally comprising, connected in parallel with the output switches, a set of switches and means for dephasing the command signals of the switches of said set, in relation to the command signals of the input and ouput switches.

9. Frequency-tracking filter according to any one of claims 4 to 7, characterized in that each channel comprises a second switch ($I_2$) commanded by the command means (M), the first of the switches ($I_1$) putting the channel in communication with the input, the other ($I_2$) putting it in communication with the output, the filter additionally comprising a set of switches, and means for commanding the switches of said set at a fixed frequency, connected in parallel with the output switches.

10. Frequency-tracking filter according to any one of claims 4 to 7, characterized in that each channel comprises a second switch ($I_2$) commanded by the command means (M) the first of the switches ($I_1$) putting the channel in communication with the input, the other ($I_2$) putting it in communication with the output, the filter additionally comprising a set of switches, and means for commanding the switches of the set at a frequency proportional to the frequency of the input signal, connected in parallel with the output switches.

**Ansprüche**

1. Umschaltbares Nachfilter mit *n*-Pfaden von der Art eines Bandpaßfilters mit schmalem Band, mit einem Blindelement (C) in jedem Pfad, welches sich in einem Querzweig des entsprechenden Pfades befindet, welcher einerseits mit einem Bezugspunkt und andererseits mit einem zwischen dem Eingang (E) und dem Ausgang (S) des Filters liegenden Punkt des Pfades verbunden ist, wobei jeder Pfad mittels wenigstens eines Schalters (I, $I_1$, $I_2$) umgeschaltet wird, welcher durch Steuermittel (M) zum Öffnen und zum Schließen gesteuert wird, die am Ausgang (S) des Filters ein Synchronisationssignal für das Umschalten der *n*-Pfade abnehmen, dadurch gekennzeichnet, daß der Querzweigzwischen dem Bezugspotential und dem Punkt, welcher auf dem Pfad zwischen dem Eingang (E) und dem Ausgang (S) des Filters liegt, eine bei dem Pfad zugeordneten, geschlossenen Schalter in Reihe mit dem Blindelement (C) geschaltete Änderungsimpedanz aufweist, durch die somit aufgrund ihrer Dimensionierung die Übertragungsfunktion des Filters derart verändert wird, daß vor dem Einfangen des Eingangssignals mit veränderbarer Frequenz ein Teil der Amplitude dieses Eingangssignals am Ausgang des Filters forbesteht.

2. Filter nach Anspruch 1, dadurch gekennzeichnet, daß daß jeder Querzweig eine bestimmte Änderungsimpedanz (T) enthält.

3. Filter nach Anspruch 1, dadurch gekennzeichnet, daß die Querzweige an einem gemeinsamen Punkt verbunden sind und daß die allen Pfaden gemeinsame Änderungsimpedanz (T) zwischen disem Punkt und dem Bezugspotential geschaltet ist.

4. Umschaltbares Filter nach irgendeinem der Ansprüche 2 und 3, dadurch gekennzeichnet, daß die Änderungsimpedanz einen parallel mit einem Kondensator geschalteten Widerstand umfaßt.

5. Umschaltbares Nachfilter nach irgendeinem der Ansprüche 2 und 3, dadurch gekennzeichnet, daß die Impedanz einen einstellbaren Widerstand umfaßt, welcher parallel mit einem Kondensator geschaltet ist.

6. Umschaltbares Nachfilter nach irgendeinem der Ansprüche 2 und 3, dadurch gekennzeichnet, daß es Mittels aufweist, um die Impedanz während des Betriebes des Filters zu unterdrücken.

7. Umschaltbares Nachfilter nach irgendeinem der Ansprüche 1 bis 6, dadurch gekennzeichnet, daß die Steuermittel (M) zum Öffnen und Schließen einen Verstärker mit automatischer Verstärkungssteuerung umfassen, der mit dem Ausgang des Filters derart verbunden ist, daß das an diesem Ausgang abgenommene Synchronisationssignal verstärkt wird.

8. Umschaltbares Nachfilter nach irgendeinem der Ansprüche 4 bis 7, dadurch gekennzeichnet, daß jeder Pfad einen weiteren durch die Umschaltmittel (M) gesteuerten Schalter ($I_2$) aufweist, wobei durch einen der Schalter ($I_1$) dieser Pfad mit dem Eingang und durch den anderen ($I_2$) dieser Pfad mit dem Ausgang verbindbar ist, und daß das Filter ferner einen Satz Schalter, die parallel zu den Schaltern für den Ausgang verbunden sind, und Mittel umfaßt, um die Steuersignale für den Satz der Schalter in bezug auf die Steuersignale der Schalter für den Eingang und den Ausgang außer Phase zu bringen.

9. Umschaltbares Nachfilter nach irgendeinem der Ansprüche 4 bis 7, dadurch gekennzeichnet, da, jeder Pfad einen weiteren durch die Umschaltmittel (M) gesteuert, Schalter ($I_2$) aufweist, wobei durch einen der Schalter ($I_1$) der Weg mit dem Eingang und durch den anderen ($I_2$) dieser Weg mit dem Ausgang verbindbar ist, und daß das Filter ferner einen Satz von parallel zu den Schaltern für Schalter dieses Satzes mit einer festen Frequenz aufweist.

10. Umschaltbares Nachfilter nach irgendeinem der Ansprüche 4 bis 7, dadurch gekennzeichnet, daß jeder Pfad einen weiteren von den Umschaltmitteln (M) gesteuerten Schalter ($I_2$) aufweist, wobei durch einen der Schalter ($I_1$) dieser Pfad mit dem Eingang und durch den anderen ($I_2$) dieser Pfad mit dem Ausgang verbindbar ist, und daß das Filter ferner einen Satz von parallel zu den Schaltern fü den Ausgang geschaltete Schalter und Mittel aufweist, um die Schalter dieses Satzes mit einer Frequenz, welche der Frequenz des Eingangssignals proportional ist, zu steuern.

FIG.1

0 014 628

1

FIG.2

FIG.3

FIG.4

FIG.5

FIG.6

FIG.7

FIG.8

FIG. 9

FIG. 10

FIG. 11